# EUROPEAN PATENT APPLICATION

(11) **EP 4 657 187 A1**
(43) Date of publication of application: **03.12.2025**
(21) Application number: 24178518.7
(22) Date of filing: 28.05.2024
(51) Int. Cl.: G05B 19/418, G05B 17/02

(54) **AUTOMATIC SIMULATION MODEL GENERATION OF MODULAR ENGINEERED PROCESS PLANTS**

(71) Applicant: ABB SCHWEIZ AG, 5400 Baden (CH)
(72) Inventor: HOERNICKE, Mario, 76829 Landau (DE); STARK, Katharina, 69469 Weinheim (DE); SCHOCH, Nicolai, 69120 Heidelberg (DE); GRUENER, Sten, 69514 Laudenbach (DE); BECKER, Pascal, 76676 Graben-Neudorf (DE); BRAUN, Roland, 53859 Niederkassel Lülsdorf (DE); ESKANDANI, Nafise, 64380 Rossdorf (DE); THODE, Sara Emilie, 0661 Oslo (NO); LINSBAUER, Lukas, 69221 Dossenheim (DE)
(74) Representative: Zimmermann & Partner Patentanwälte mbB

(57) **Abstract**

A method (100) of simulating a process section of an industrial process is provided. The method comprises obtaining (110) a model of mechanical flows (210) within the process section; obtaining (120) a state-based control logic (320) describing interactions between equipment associated to the process section; providing (130) a simulation model for the process section based on the model of mechanical flows and the control logic; and simulating (140) the process section based on the simulation model. Providing the simulation model comprises automatically interpreting (131, 132) the model of mechanical flows and the control logic; and automatically integrating (133) interactions between the model of mechanical flows and the control logic.

## Description

### TECHNICAL FIELD

Embodiments of the present disclosure relate to a method of simulating a process section of an industrial process. Further embodiments relate to a non-volatile data storage medium containing, as data recorded thereon, a simulation model of a process section of an industrial process.

### BACKGROUND

In industrial plants, automation systems that control industrial processes, exemplarily chemical or pharmaceutical processes, play an important role to ensure efficient and safe operation. Automation systems are tested against specific scenarios, with different use cases being implemented by forcing specific parameter values and observing the reaction of the automation system. Such an approach may be described as factory acceptance test, or FAT. Another, or additional approach, tests the automation system after implementation in the industrial plant, monitoring the industrial process and its physical behavior.

However, both verification and validation processes are conducted with the automation system being in an evolved state of development and require a large amount of manual work. Thus, addressing unintended behavior or optimizing the automation system based on the verification and validation processes is complex and costly. Similarly, creating a simulation environment, in which the industrial process, or a process section of the industrial process, may be tested, is complex and potentially a highly manual task. An automated process that generates simulation models for process sections of industrial plants for the verification and validation of automation systems, and in particular their control logics, is lacking.

### DISCLOSURE OF THE INVENTION

In the view of the foregoing, the present disclosure is directed to a method of simulating a process section of an industrial process and a non-volatile data storage medium containing, as data recorded thereon, a simulation model of a process section of an industrial process, the simulation model obtained by a method according to one of the embodiments described herein. The method allows to simulate the process section based on an automatically generated simulation model of the process section.

According to an aspect of the present disclosure, a method of simulating a process section of an industrial process is provided. The method comprises obtaining a model of mechanical flows within the process section; obtaining a state-based control logic describing interactions between equipment associated to the process section; providing a simulation model for the process section based on the model of mechanical flows and the control logic. Providing the simulation model comprises automatically interpreting the model of mechanical flows and the control logic; and automatically integrating interactions between the model of mechanical flows and the control logic. The method further comprises simulating the process section based on the simulation model.

According to another aspect of the present disclosure, a non-volatile data storage medium is provided. The non-volatile data storage medium contains, as data recorded thereon, a simulation model of a process section of an industrial process. The simulation model is obtained by a method according to any of the embodiments described herein.

According to some embodiments, the industrial process comprises a plurality of, particularly modular, process sections. In particular, the industrial process may be composed of a plurality of modular process sections. In other words, the industrial process may be subdivided in process sections with each process section interacting with at least one other second process section. The industrial process may be a production process or a mining process. In particular, the industrial process may be a pharmaceutical or a chemical process.

In typical embodiments, a process section of the industrial process may be a functional unit of the industrial process. In particular, the process section may comprise a plurality of machinery being assembled to achieve a change in a physical or chemical property of a material. Exemplarily, the process section comprises a vessel in which a liquid or gas is stored and heated or cooled and from which the gas or liquid may be distributed to further process sections, exemplarily a chemical reactor. The exemplary process section may comprise a plurality of sensors such as thermometers, state sensors, flow sensors or pressure sensors, and actuators such as valves or pumps.

Typically, a process section comprises mechanical flows. The mechanical flows of a process section may comprise liquid flows or gas flows, flows of solid materials or flows of reactants and products. In some embodiments, the mechanical flows may comprise flows of process heat. In some embodiments, the mechanical flows may comprise flows of auxiliary materials, that may support the functioning of the process section.

The mechanical flows within the process section are described by a model of mechanical flows. The model of mechanical flows may be obtained from a graphical representation of the process section (e.g., from a user input, in particular using a graphical interface representing the process section; the model of mechanical flows may be additionally or alternatively be obtained in any other manner, e.g., by receiving from an input terminal, by generating from process plant data, and/or the like). In particular, the graphical representation of the process section may reduce the representation of the process section to abstract functional relations between different components of the process section. In other words, the graphical representation is an abstract representation of the process section. Exemplarily, physical dimensions may be shown distorted in the abstract representation of the process section. In some embodiments, the functional relations between the different components of the process section may be represented by a limited set of simplified, exemplarily visual, indicators.

In typical embodiments, the graphical representation of the process section comprises a human machine interface, HMI. The HMI typically is a representation of the process section as displayed to an operator. In particular, the HMI simplifies the process section to functional relations between the different components of the process section. In some embodiments, the HMI may be configured to receive a user input.

In some embodiments, the graphical representation of the process section comprises a piping and instrumentation diagram, P&ID, which may also be described as mechanical flow diagram. The P&ID shows components of the process section and physical connections, in particular piping, connecting those components. The P&ID may further comprise instrumentation, in particular sensors, and control devices, in particular actuators.

In typical embodiments, the model of mechanical flows is a low-fidelity model. This may advantageously allow to employ a low-fidelity graphical representation of the process section. Further, a low-fidelity model also simplifies simulating the process section. The low-fidelity model typically focusses on key interactions between components of the process section and may advantageously be applied to a plurality of specific physical representations of the process section and/or of automation hardware.

In some embodiments, the state-based control logic describes interactions between equipment associated to the process section. In particular, the state-based control logic may change a parameter of a component of the process section when another component, or the same component, is in a predefined state or the state of the component changes. In other words, the state-based control logic describes how the process section, and its components, reacts upon changing parameters, in particular within the process section. The state-based control logic may be implemented with a plurality of cause-and-effect, C&E, matrixes. Each of the C&E matrixes associates a plurality of states of components of the process section with respective commands that may change a property of equipment of the process section. Each change of a state of a component may trigger employing another C&E matrix. Exemplarily, one of the C&E matrixes may associate a temperature state of a liquid in a vessel, such as the temperature exceeding a threshold, with a command that reduces a heating of the liquid, in particular a command that stops an operation of a heating device. Similarly, a filling level in a vessel may exceed a threshold, changing a filling state of the vessel, and may be associated with closing a valve of a liquid flow towards the vessel.

In some embodiments, the control logic comprises services of the process section. In particular, the control logic may provide commands to components of the process section depending on the service provided. The services of the process section share a state machine. In other words, definitions of the states of the process section are independent of the service provided by the process section. However, the control commands provided by the control logic may vary for different services provided.

In the simulation model, the state-based control logic and the model of mechanical flows may be integrated (so that the simulation models the mutual interactions between these two elements). This integrated simulation can, for example, be carried out by providing a discrete-time simulation in which mutual interactions between the model of mechanical flows and the control logic are implemented. In particular, a command of the control logic is transmitted to the model of mechanical flows. In the model of mechanical flows, a parameter of a component of the process section changes according to the command. Exemplarily, the control logic may provide a command for a specific valve to change its state from "open" to "closed" and the valve parameter accordingly changes from "open" to "closed" in the model of mechanical flows. In the model of mechanical flows, a change of a property or parameter of a component may be associated with changes of properties of other components. For the example above, the closed valve may lead to a decreasing filling level of a vessel if outflows of liquid or gas remain unchanged.

In the simulation model, a state of a service in the control logic may be changed in response to a threshold being reached in the model of mechanical flows. Exemplarily, once a filling level of a vessel exceeds a threshold, the state of the vessel in the control logic, in particular with respect to a C&E matrix, may change to "full". The changing state of service in the control logic, in the example the vessel being "full", may be associated with selecting a C&E matrix and a command being sent from the control logic to the model of mechanical flows, exemplarily for a valve to close.

The model of mechanical flows and the control logic are interpreted automatically. In particular, for each equipment of the process section referenced in the state-based control logic, an associated equipment in the model of mechanical flows has to be identified and be linked. Vice versa, for each equipment described in the model of mechanical flows, a change of a property of the equipment in reaction to a command of the control logic has to be associated. In some embodiments, associating the equipment of the process plant with the control logic is performed using tags, with each tag corresponding to a piece of equipment of the process section. For each piece of equipment, associated with a tag, default parameter values may be determined and may be stored in a tag list.

Interpreting the model of mechanical flows and the control logic automatically may advantageously allow to provide a simulation model at an early and/or conceptional stage to test the automation systems, in particular the control logic. In particular, a developer may test a control logic for a process section, or a plurality of process sections by starting the simulation model without complex manual development of such a model. Exemplarily, the developer may test a plurality of alternative control logics and compare the plurality of alternative control logics based upon a performance metric. The automatic interpretation of the model of mechanical flows and the control logic advantageously allows to test a control logic at the push of a button.

In some embodiments, the model of mechanical flows and the control logic are interpreted employing a trained machine learning model. In particular, the trained machine learning model may be trained upon labeled P&ID modules and/or labeled HMI. The trained machine learning module can identify a graphical representation of equipment of a process section and the mechanical flows between the equipment of the process section. Employing a trained machine learning model may advantageously allow to build simulation models for process sections which are described in a non-standard way or of which only a graphical representation of the model of mechanical flows or the control structure is available. Exemplarily, employing a trained machine learning model may allow to build simulation models for process sections or equipment provided by different and/or a plurality of manufacturers, in particular when combining process sections provided by different manufacturers into a single industrial process.

In some embodiments, the simulation model may be implemented in a programming environment. Exemplarily, the simulation model may be implemented using a .NET, a Python, a Java, or a C-framework. In particular, class structures for equipment of the process section may be implemented in the programming environment. Different instances may be connected, in particular automatically.

In some embodiments, the simulation model comprises a standardized interface to connect the simulation model with other models, and/or automation hardware. Exemplarily, the simulation model may comprise an OPC UA server, providing an OPC UA interface. The simulation model may be executed in an engineering tool. Employing a standardized interface advantageously allows to avoid specific tools and facilitates employing the simulation model to engineer and/or control the industrial process. In particular, the simulation model may be externalized and may be executed by another user, exemplarily a customer or a manufacturer of an adjacent process module.

To simulate a plurality of process section, in particular of interacting process sections, a plurality of simulation models of the plurality of process sections may be connected. In particular, interactions between adjacent process sections may be implemented.

Typically, for every process section of the plurality of process sections of industrial process, a simulation model may be generated. In particular, the process section may be a first process section of the plurality of process sections of the industrial process and the industrial process may comprise a second process section. A second simulation model may provide a model for the second process section. The second simulation model is typically provided according to the embodiments described herein. In particular, the model of mechanical flows and the control logic of the second process section are automatically interpreted and interactions between the model of mechanical flows and the control logic of the second process section are automatically integrated.

In some embodiments, the simulation model and the second simulation model are connected by automatically modeling interactions of the simulation model with the second simulation model. In particular, output parameters of the simulation model may be automatically connected with input parameters may be automatically connected. Exemplarily, an output of a mechanical flow of the simulation model may be connected with an input of a mechanical flow of the same type of the second simulation model. Output parameters, in particular of a mechanical flow, may comprise a density, a temperature, a pressure, a volume flow and/or a, particularly discrete, state of a flow of a medium between the process section and the second process section. In some embodiments, the output parameters may comprise a composition of a mechanical flow, exemplarily the chemical composition of a fluid flowing from the process section to the second process section.

In some embodiments, the simulation model and the second simulation model may comprise standardized interfaces for inputs and/or outputs of mechanical flows. In particular, for specific types of mechanical flows, the standardized interfaces may comprise a standardized set of features. Exemplarily, the standardized set of features may comprise a volume flow, a pressure and/or a temperature of the medium. The parameters of the standardized set of features may be exchanged between the simulation model and the second simulation model. Employing standardized interfaces advantageously allows to connect simulation models with second simulation models provided by a third party, exemplarily another manufacturer of equipment. Exemplarily, in the industrial process, a process section manufactured by a first manufacturer, with a simulation model provided by the first manufacturer, may be combined with a second process section manufactured by a second manufacturer, with a second simulation model provided by the second manufacturer. When simulating the combination of the first process section and the second process section, the simulation model and the second simulation model may be combined.

In some embodiments, the standardized interfaces of the simulation model may allow to connect the simulation model and/or the second simulation model with automation hardware, sensors or process management software. According to some embodiments, in particular if the simulation model and/or the second simulation model comprises interfaces that are not connected to another simulation model and/or hardware, default parameter values may be provided via the interfaces.

For a plurality of process sections of an industrial plant, the plurality of process sections may be controlled by a higher level entity, exemplarily a process control system (PCS). In particular, the control logic on a higher level than the specific process sections may be described by a sequential functional chart (SFC). The SFC may describe the control logic on the level of the industrial process. Typically, the SFC describes the industrial process in a sequence of steps. During every step of the SFC, services of the process sections are being called according to the SFC. To proceed within the SFC, in other words to proceed from one step of the SFC to the next one, typically a specified state has to be reached. Once a threshold is reached and/or the state changes in the simulation model, the states in the simulation model are read and/or transmitted from the simulation model and the control logic on a higher level may proceed. Further, control commands from the SFC may be received by the simulation model.

Once the simulation model is completed, the simulation is carried out (whereby the process section is simulated based on the simulation model). This step of "simulating" includes running the simulation, e.g., in discrete time steps. For this purpose, the simulation model may be made available for use within other tools. In particular, the simulation may be loaded into an engineering tool, in particular in a down-stripped version of an engineering tool. In typical embodiments, the simulation model may comprise a configuration file, that, when loaded into the engineering tool, allows to perform the simulation in the simulation model. Connecting the simulation model with other simulations, in particular with other simulation models, may be performed based on process parameters of the process section. In some embodiments, the process parameters may be accessible via an OPC UA server. Typically, a plurality of process parameters may be described in a standardized format, exemplarily in a modular type package (MTP) file. This may advantageously allow to employ the process parameters in a higher level process orchestration layer (POL) or other simulation systems. Employing standardized interfaces advantageously allows to employ the simulation model both isolated in the engineering tool as well as in conjunction with other simulation models and simulation environments. In particular, a plurality of simulation models may be combined to allow a simulation of the industrial process and/or an industrial plant.

In some embodiments, the simulation model is used along the life cycle of the industrial plant carrying out the industrial process. In particular, the simulation model may be improved and be tailored towards a specific use case along the life cycle. The simulation model may be employed at an early stage of the development of the process module, in particular with the process module, and the associated simulation module, being independent of a specific physical representation of automation hardware of the process section. In particular, sensors, controllers and interfaces are only present on an abstract level, but not as a physical hardware. Exemplarily, only a type of equipment, with performance requirements, may be defined, but not a specific device that fulfills the performance requirements.

At the early stage of development, the simulation model is executed in a simulation environment, exemplarily in the engineering tool. At this stage, with no physical automation hardware being present, the simulation model can advantageously be used to verify general properties of the control logic. Further, the quality of the simulation model may be analyzed. At the early stage, different control logics may be tested and compared with each other. In particular, an engineer may test a modification of the control logic at the push of a button. In some embodiments, at the early stage, an integration of a plurality of process modules, particularly to form the industrial process, may be tested.

At a later stage, for a specific process section with the associated automation hardware being known, an interaction between the simulation model and the automation hardware may be established. In particular, the control logic may be executed on the automation hardware. This may allow to advantageously identify potential incompatibilities with properties of specific automation hardware. If specific properties of the physical processes in a specific process section is available, the model of mechanical flows may be replaced by a medium fidelity simulation environment, exemplarily a factory acceptance test environment. The medium fidelity simulation environment is typically dedicated to a specific set-up of the process section with a specific control system. The medium fidelity simulation environment may be employed to perform a virtual commissioning or Factory Acceptance Test (FAT).

All levels of the simulation model may be employed for operator training. In particular, a more abstract simulation model, executed in the simulation environment without a specific physical representation of automation hardware of the process section, may be employed to present general properties and relations of the control logic of the process section. More specific models that incorporate specific automation hardware may be employed to teach the operator the behavior of a specific representation of the process section.

The simulation model, as obtained by the methods described herein, may be recorded on a non-volatile data storage medium. In some embodiments, the simulation model may be generated and/or recorded in a cloud computing environment. In particular, the model of mechanical flows and the control logic may be interpreted in a cloud computing environment. Employing a cloud computing environment advantageously allows to optimize interpretation algorithms centrally and, in particular when using a machine learning algorithm for interpretation, using scale effects.

In some embodiments, a non-volatile data storage medium, or a cloud computing environment, may comprise a database of simulation models which may be combined to form models of the industrial process. In particular, standard process sections may be provided as second process sections with second simulation models to complement a process section of an industrial process to be simulated.

Embodiments of the present disclosure may allow to automatically generate simulation models from available engineering information of process sections, and by combining the simulation models, a simulation model for an industrial plant comprising a plurality of process sections. Thereby, it becomes possible to realistically model both the underlying physical process (in terms of the mechanical flows) and the control logic in a single integrated simulation and without the need of providing the actual control hardware. Embodiments may allow to improve control logics of automation and control systems of industrial plants. Embodiments may allow an earlier verification and validation of the automation system.

### BRIEF DESCRIPTION OF THE DRAWINGS

The accompanying drawings relate to embodiments of the disclosure and are described in the following:
- FIG 1: schematically illustrates a method of simulating a process section of an industrial process according to embodiments described herein;
- FIG 2: schematically describes a part of the method of simulating a process section of an industrial process, in particular automatically interpreting the model of mechanical flows;
- FIG 3: schematically describes a part of the method of simulating a process section of an industrial process, in particular automatically interpreting the control logic;
- FIG 4: schematically describes connecting the simulation model to a second simulation model.

### DETAILED DESCRIPTION OF EMBODIMENTS

Reference will now be made in detail to the various embodiments of the disclosure, one or more examples of which are illustrated in the figures. Generally, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield a further embodiment. It is intended that the description includes such modifications and variations.

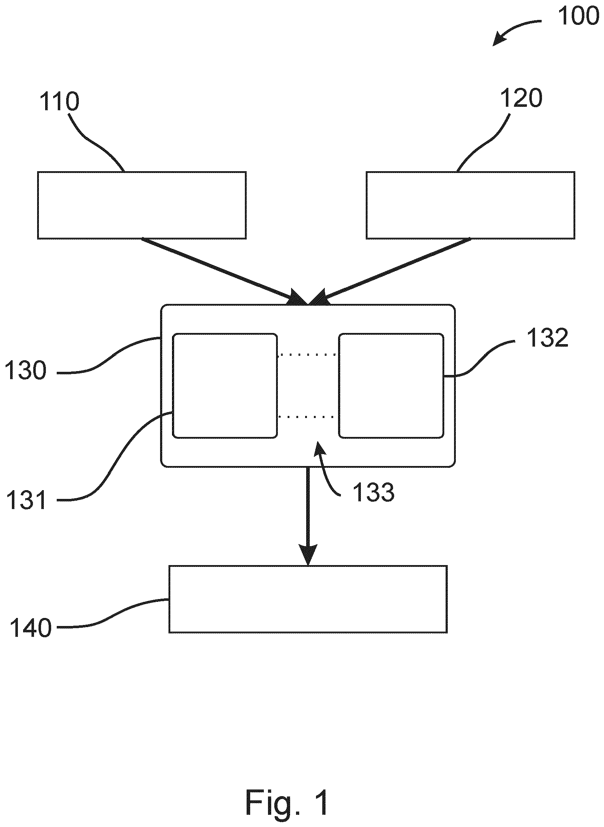

FIG 1 schematically illustrates a method 100 of simulating a process section of an industrial process. The method 100 comprises obtaining 110 a model of mechanical flows within the process section. The method 100 further comprises obtaining 120 a state-based control logic describing interactions between equipment associated to the process section. The model of mechanical flows obtained 110 and the state-based control logic obtained 120 are used to provide 130 a simulation model for the process section. Providing 130 the simulation model for the process section comprises automatically interpreting 131 the model of mechanical flows and automatically interpreting 132 the control logic. Further, providing 130 the simulation model for the process section comprises automatically integrating 133 interactions between the model of mechanical flows and the control logic. The simulation model provided 130 is used to simulate 140 the process section.

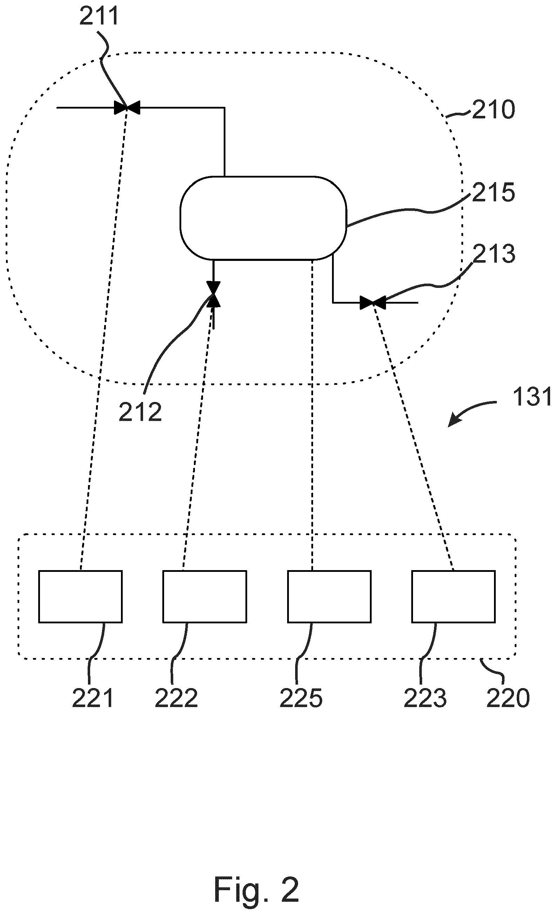

FIG 2 schematically describes the automatic interpretation 131 of the model of mechanical flows 210. In FIG 2, the model of mechanical flows 210 is a simplified HMI-style graphical representation of a vessel 215 with three pipes, each associated with a valve 211, 212, 213, being connected with the vessel 215. The first valve 211 controls a flux of a liquid into the vessel 215. The second valve 212 and the third valve 213 each control a flux of the liquid leaving the vessel 215. By controlling the first valve 211 and the second valve 212 and/or the third valve 213, a filling level of the liquid in the vessel 215 may be adjusted. The automatic interpretation 131 associates each of the components of the model of mechanical flows 210 with a tag 221, 222, 223, 225. Each tag 221, 222, 223, 225 corresponds to a piece of equipment of the process section as represented by the model of mechanical flows 210. In particular, the first tag 221 corresponds to the first valve 211, the second tag 222 corresponds to the second valve 212, the third tag 223 corresponds to the third valve 213 and the fourth tag 225 corresponds to the vessel 215. The tags 221, 222, 223, 225 are stored in a tag list 220.

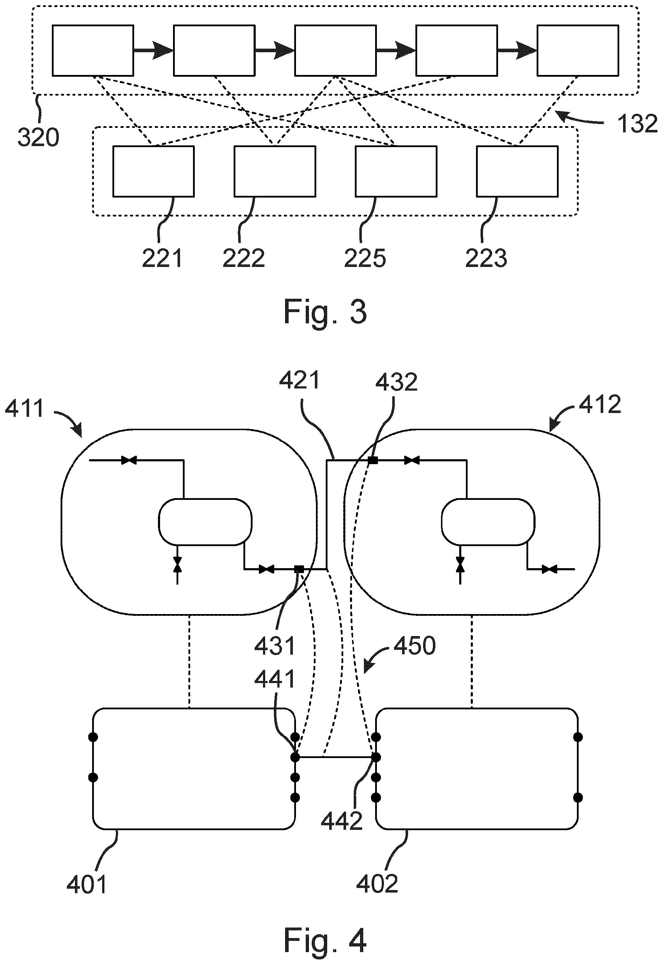

FIG 3 schematically describes the automatic interpretation 132 of the control logic 320. The control logic 320 comprises a plurality of commands. In the example of FIG 3, the commands are executed subsequently. However, more complex or parallel control structures can be conceived. The automatic interpretation 132 of the control logic 320 comprises associating the commands with the tags 221, 222, 223, 225. In particular, for each command a corresponding piece of equipment, as represented by a tag 221, 222, 223, 225, is associated. Some commands may be associated with a plurality of tags 221, 222, 223, 225. Some pieces of equipment, and thus tags 221, 222, 223, 225, may be associated with a plurality of commands.

FIG 4 schematically illustrates connecting the simulation model, as a first simulation model 401, to a second simulation model 402. The first simulation model 401 is associated to a first process section 411. The second simulation model 402 is associated to a second process section 412. The first process section 411 comprises an output module 431 where a material flow leaves the first process section 411. In the graphical representation of FIG 4, the output module 431 is represented by dots in the graphical representation of the first simulation model 401, providing the output parameters 441 of the first simulation model 401. Typically, the output parameters 441 are provided in a standard format. The first process section 411 interacts with the second process section 412 via an interaction 421. The interaction 421, which in the example of FIG 3 may be a pipe, connects the output module 431 with an input module 432 of the second process section 412. The input module 432 is represented by dots in the graphical representation of the second simulation model 402. In the second simulation model 402, the output parameters 441 of the first simulation model 402 are received as input parameters 442 of the second simulation model 402. From the graphical representation of the first process section 411 and of the second process section 412, in particular when integrated in a graphical representation of an industrial process or an industrial plant, interactions 421 between the first process section 411 and the second process section 412 are automatically modelled 450. Automatically modelling 450 the interactions 421 in particular comprises automatically identifying output modules 431 and input modules 432 and associating the output modules 431 and the input modules 432 with output parameters 441 and input parameters 442, respectively.

## Claims

1. A method (100) of simulating a process section of an industrial process, the method comprising:
obtaining (110) a model of mechanical flows (210) within the process section;
obtaining (120) a state-based control logic (320) describing interactions between equipment associated to the process section;
providing (130) a simulation model for the process section based on the model of mechanical flows and the control logic; and
simulating (140) the process section based on the simulation model;
wherein providing the simulation model comprises
automatically interpreting (131, 132) the model of mechanical flows and the control logic; and
automatically integrating (133) interactions between the model of mechanical flows and the control logic.

2. The method of claim 1, wherein the simulation model is an abstract simulation model independent of a specific physical representation of automation hardware of the process section.

3. The method of any of the preceding claims, wherein the model of mechanical flows is based upon a graphical representation, in particular a human machine interface, of the process section.

4. The method of claim 3, wherein parameters of the model of mechanical flows are interpreted automatically from the graphical representation of the process section.

5. The method of any of the preceding claims, wherein the control logic comprises services of the process section.

6. The method of any of the preceding claims, wherein integrating interactions between the model of mechanical flows and the control logic comprises transmitting a command of the control logic to the model of mechanical flows and changing a parameter of a component of the process section in the model of mechanical flows according to the command.

7. The method of any of the preceding claims, wherein integrating interactions between the model of mechanical flows and the control logic comprises changing a state of a service in the control logic in response to a threshold being reached in the model of mechanical flows.

8. The method of any of the preceding claims, wherein the process section is a first process section (411) of a plurality of process sections of the industrial process, the method further comprising
connecting the simulation model (401) to a second simulation model (402) for a second process section (412) of the plurality of process sections of the industrial process,
wherein connecting the simulation model to the second simulation model comprises automatically modeling (450) interactions (421) of the simulation model with the second simulation model.

9. The method of claim 8, wherein automatically modeling interactions of the simulation model with the second simulation model comprises automatically connecting output parameters (441) of the simulation model with input parameters (442) of the second simulation model.

10. The method of any of claims 8 to 9, wherein interactions of the simulation model with the second simulation model comprise a mechanical flow of a medium between the process section and the second process section.

11. The method of claim 10, wherein connecting the simulation model comprises automatically exchanging information on the pressure of the medium, on the density of the medium and/or on a temperature of the medium.

12. The method of any of the preceding claims, further comprising providing an OPC UA interface to externalize the simulation model.

13. The method of any of the preceding claims, wherein automatically interpreting the model of mechanical flows and the control logic comprises employing a trained machine learning model.

14. The method of any of the preceding claims, further comprising establishing an interaction between the simulation model and automation hardware of the process section.

15. A non-volatile data storage medium containing, as data recorded thereon, a simulation model of a process section of an industrial process, the simulation model obtained by a method according to any one of the preceding claims.
